# EUROPEAN PATENT APPLICATION

(11) **EP 3 199 505 A1**
(43) Date of publication of application: **02.08.2017**
(21) Application number: 17152043.0
(22) Date of filing: 18.01.2017
(51) Int. Cl.: C04B 41/85, C04B 41/89, F01D 5/28

(54) **PLASMA SPRAY PHYSICAL VAPOR DEPOSITION DEPOSITED ENVIRONMENTAL BARRIER COATING INCLUDING A LAYER THAT INCLUDES A RARE EARTH SILICATE AND CLOSED POROSITY**

(30) Priority: 29.01.2016 US 201662289075 P
(71) Applicant: Rolls-Royce Corporation, Indianapolis, Indiana 46225 (US)
(72) Inventor: Lee, Kang, Strongsville, IN 44135 (US); Gold, Matthew, Carmel, IN 46033 (US); Gong, Stephanie, Indianapolis, IN 46204 (US)
(74) Representative: Rolls-Royce plc

(57) **Abstract**

An article includes a substrate defining at least one at least partially obstructed surface. The substrate includes at least one of a ceramic or a ceramic matrix composite. The article also includes an environmental barrier coating on the at least partially obstructed substrate. The environmental barrier coating includes a layer including a rare earth disilicate and a microstructure comprising closed porosity.

## Description

### TECHNICAL FIELD

The disclosure relates to techniques for forming environmental barrier coatings using plasma spray physical vapor deposition.

### BACKGROUND

Ceramic or ceramic matrix composite (CMC) materials may be useful in a variety of contexts where mechanical and thermal properties are important. For example, components of high temperature mechanical systems, such as gas turbine engines, may be made from ceramic or CMC materials. Ceramic or CMC materials may be resistant to high temperatures, but some ceramic or CMC materials may react with some elements and compounds present in the operating environment of high temperature mechanical systems, such as water vapor. Reaction with water vapor may result in the recession of the ceramic or CMC material. These reactions may damage the ceramic or CMC material and reduce mechanical properties of the ceramic or CMC material, which may reduce the useful lifetime of the component. Thus, in some examples, a ceramic or CMC material may be coated with an environmental barrier coating, which may reduce exposure of the substrate to elements and compounds present in the operating environment of high temperature mechanical systems.

### SUMMARY

In some examples, the disclosure described an article that includes a substrate defining at least one at least partially obstructed surface. The substrate includes at least one of a ceramic or a ceramic matrix composite. The article also may include an environmental barrier coating on the at least partially obstructed substrate. The environmental barrier coating includes a layer including a rare earth disilicate and a microstructure comprising closed porosity.

The layer may consist essentially of the rare earth disilicate.

The layer may be substantially free of open pores.

The layer may further comprise at least one of alumina, at least one alkali oxide, or at least one alkaline earth oxide.

The article may further comprise a silicon bond coat layer between the substrate and the environmental barrier coating.

The silicon bond coat layer may comprise closed porosity and may be substantially free of open pores.

The layer may further comprise barium-strontium-aluminosilicate.

The layer may comprise a first layer, further comprising a second layer on the first layer, wherein the second layer may comprise a columnar microstructure and a rare earth disilicate or may comprise barium-strontium-aluminosilicate and closed porosity.

The layer may comprise a first layer, further comprising: a second layer on the first layer, wherein the second layer may comprise a columnar microstructure and a rare earth disilicate; a third layer on the second layer, wherein the third layer may comprise a rare earth disilicate and closed porosity; and a fourth layer on the third layer, wherein the fourth layer may comprise a columnar microstructure and a rare earth disilicate.

In some examples, the disclosure describes a system that includes a vacuum pump, a vacuum chamber, a plasma spray device, a coating material source, and a computing device. The computing device is configured to control the vacuum pump to evacuate the vacuum chamber to high vacuum. The computing device also is configured to control the coating material source to provide a coating material to the plasma spray device at a feed rate, the coating material having a composition selected so that a layer formed from the coating material comprises a rare earth disilicate, and the feed rate being selected to result in a microstructure including closed porosity. The computing device is further configured to control the plasma spray device to deposit the layer on a substrate in the vacuum chamber using plasma spray physical vapor deposition. The layer includes the rare earth disilicate and closed porosity.

The layer may consist essentially of the rare earth disilicate, and wherein the coating material may comprise excess silica compared to the stoichiometric ratio of rare earth oxide to silica in the rare earth disilicate.

The layer may further comprise at least one of alumina, at least one alkali oxide, or at least one alkaline earth oxide, and wherein the coating material may further comprise the at least one of alumina, the at least one alkali oxide, or the at least one alkaline earth oxide.

The computing device may be further configured to: control the coating material source to provide a coating material comprising silicon metal to the thermal spray device; control the plasma spray device to deposit a bond coat layer on the substrate in the vacuum chamber using plasma spray physical vapor deposition, wherein the layer including the rare earth disilicate is on the bond coat layer.

The silicon bond coat layer may comprise closed porosity and may be substantially free of open pores.

The layer may further comprise barium-strontium-aluminosilicate, and wherein the coating material may further comprise barium-strontium-aluminosilicate.

The layer may comprise a first layer, the coating material may comprise a first coating material, the feed rate may comprise a first feed rate, and wherein the computing device may be further configured to: control the coating material source to provide a second coating material to the plasma spray device at a second feed rate, the second coating material having a composition selected so that a layer formed from the coating material comprises a rare earth disilicate, and the feed rate being selected to result in a columnar microstructure; and control the plasma spray device to deposit the second layer on the first layer in the vacuum chamber using plasma spray physical vapor deposition, wherein the second layer comprises the rare earth disilicate and columnar microstructure.

The layer may comprise a first layer, the coating material may comprise a first coating material, the feed rate may comprise a first feed rate, and wherein the computing device may be further configured to: control the coating material source to provide a second coating material to the plasma spray device at a second feed rate, the second coating material having a composition selected so that a layer formed from the coating material comprises a barium-strontium-aluminosilicate, and the feed rate being selected to result in closed porosity; and control the plasma spray device to deposit the second layer on the first layer in the vacuum chamber using plasma spray physical vapor deposition, wherein the second layer comprises the barium-strontium-aluminosilicate and closed porosity.

In some examples, the disclosure describes a method that includes controlling, by a computing device, a vacuum pump to evacuate the vacuum chamber to high vacuum. The method also includes controlling, by the computing device, a coating material source to provide a coating material to the plasma spray device at a feed rate, the coating material having a composition selected so that a layer formed from the coating material comprises a rare earth disilicate, and the feed rate being selected to result in a microstructure including closed porosity. The method additionally includes controlling, by the computing device, the plasma spray device to deposit the layer on a substrate in the vacuum chamber using plasma spray physical vapor deposition. The layer includes the rare earth disilicate and closed porosity.

The layer may consist essentially of the rare earth disilicate, and wherein the coating material may comprise excess silica compared to the stoichiometric ratio of rare earth oxide to silica in the rare earth disilicate.

The method may further comprise: controlling, by the computing device, the coating material source to provide a coating material comprising silicon metal to the thermal spray device; controlling, by the computing device, the plasma spray device to deposit a bond coat layer on the substrate in the vacuum chamber using plasma spray physical vapor deposition, wherein the layer including the rare earth disilicate is on the bond coat layer.

The silicon bond coat layer may comprise closed porosity and may be substantially free of open pores.

The layer may further comprise barium-strontium-aluminosilicate, and wherein the coating material may further comprise barium-strontium-aluminosilicate.

The layer may comprise a first layer, the coating material may comprise a first coating material, the feed rate may comprise a first feed rate, and the method may further comprise: controlling, by the computing device, the coating material source to provide a second coating material to the plasma spray device at a second feed rate, the second coating material having a composition selected so that a layer formed from the coating material comprises a rare earth disilicate, and the feed rate being selected to result in a columnar microstructure; and controlling, by the computing device, the plasma spray device to deposit the second layer on the first layer in the vacuum chamber using plasma spray physical vapor deposition, wherein the second layer comprises the rare earth disilicate and columnar microstructure.

The layer may comprise a first layer, the coating material may comprise a first coating material, the feed rate may comprise a first feed rate, and the method may further comprise: controlling, by the computing device, the coating material source to provide a second coating material to the plasma spray device at a second feed rate, the second coating material having a composition selected so that a layer formed from the coating material comprises a barium-strontium-aluminosilicate, and the feed rate being selected to result in closed porosity; and controlling, by the computing device, the plasma spray device to deposit the second layer on the first layer in the vacuum chamber using plasma spray physical vapor deposition, wherein the second layer comprises the barium-strontium-aluminosilicate and closed porosity.

In some examples, the disclosure describes a computer readable storage device including instructions that, when executed, cause a computing device to control a vacuum pump to evacuate the vacuum chamber to high vacuum. The computer readable storage device also includes instructions that, when executed, cause the computing device to control a coating material source to provide a coating material to the plasma spray device at a feed rate, the coating material having a composition selected so that a layer formed from the coating material comprises a rare earth disilicate, and the feed rate being selected to result in a microstructure including closed porosity. The computer readable storage device further includes instructions that, when executed, cause the computing device to control the plasma spray device to deposit the layer on a substrate in the vacuum chamber using plasma spray physical vapor deposition. The layer includes the rare earth disilicate and closed porosity.

The details of one or more examples are set forth in the accompanying drawings and the description below. Other features, objects, and advantages will be apparent from the description and drawings, and from the claims.

### BRIEF DESCRIPTION OF DRAWINGS

FIG. 1 is a conceptual and schematic diagram illustrating an example system for forming an environmental barrier coating using plasma spray physical vapor deposition.
FIG. 2 is a conceptual block diagram illustrating an example article including a substrate and an environmental barrier coating including a layer including closed porosity and a rare earth disilicate.
FIG. 3 is a conceptual block diagram illustrating an example article including a substrate and an environmental barrier coating including a first layer including closed porosity and a rare earth disilicate and a second layer including a columnar microstructure and a rare earth disilicate.
FIG. 4 is a conceptual block diagram illustrating an example article including a substrate and a multilayer environmental barrier coating including alternating layers including closed porosity and a rare earth disilicate and including BSAS and closed porosity.
FIG. 5 is a flow diagram illustrating an example technique for forming a multilayer, multi-microstructure environmental barrier coating using plasma spray physical vapor deposition.
FIG. 6 is a scatter diagram illustrating an example relationship between excess silica in a coating material and an amount of silicon in a resulting coating.
FIG. 7 is a cross-sectional picture of an example coating deposited using PS-PVD as described in this disclosure.
FIG. 8 is a cross-sectional picture of an example coating deposited using PS-PVD as described in this disclosure.
FIG. 9 is a cross-sectional picture of an example coating deposited using PS-PVD as described in this disclosure.

### DETAILED DESCRIPTION

The disclosure describes systems and techniques for forming an environmental barrier coating (EBC) including at least one layer including a rare earth disilicate and closed porosity using plasma spray physical vapor deposition (PS PVD). EBCs protect ceramic matrix composite (CMC) substrates based on silicon from recession caused by high pressure, high velocity water vapor in environments such as combustion environments in gas turbine engines. Some EBCs are prime reliant coatings, meaning that the EBC must remain on the CMC component for the life of the CMC component. Prime reliant EBCs may fulfill multiple, competing design parameters, including water vapor stability and thermal expansion compatibility with the underlying CMC. Additionally, some prime reliant EBCs are used on surfaces that are in non-line-of-sight relationship with a coating source during manufacturing. These surfaces are referred to herein as at least partially obstructed surfaces. For example, internal surfaces of gas turbine engine blades, vanes, or bladetracks and areas between doublet or triplet vanes in gas turbine engines may not be able to be put into line-of-sight with a coating source during the manufacture of the coating.

In some examples, PS PVD may be used to deposit an EBC including at least one layer including a rare earth disilicate and closed porosity on surfaces of a CMC, including NLOS surface of the CMC. PS PVD is a flexible process that allows relatively easy adjustment of process parameters to result in coatings with different chemistry, different microstructure, or both. Rare earth disilicates have good thermal expansion compatibility with the underlying CMC.

To form a barrier to water vapor and other gaseous oxidants, many EBCs are deposited with a substantially dense or non-porous microstructure. However, this causes the EBC to have a higher modulus, which is a root cause for thermal stress in the EBC due to differential thermal expansion between the EBC and the underlying substrate under changes of temperature. This stress may eventually lead to cracking and failure of the EBC.

In accordance with examples of this disclosure, the at least one layer that includes rare earth disilicate includes closed porosity. As used herein, closed porosity means that the pores are not interconnected throughout a thickness of the at least one layer. In other words, while some pores may be interconnected within the at least one layer, the interconnection is not so extensive that a path extends from an outer surface of the at least one layer to the inner surface of the at least one layer. In this way, closed porosity is different from open porosity and is different from a columnar microstructure, both of which include paths through the thickness of a layer through which gases or vapors can migrate.

Closed porosity in the at least one layer including the rare earth disilicate may reduce the modulus of the at least one layer, thus reducing the stress caused by thermal cycling and reducing a likelihood of cracks developing in the at least one layer. Further, closed porosity does not provide paths through which water vapor can migrate from the outer surface of the at least one layer to the inner surface of the at least one layer, allowing the at least one layer to form an effective vapor barrier for the substrate. PS PVD may be used to deposit the EBC including the at least one layer including a rare earth disilicate and closed porosity, including on NLOS surfaces of the substrate.

In some examples, the at least one layer may include another constituent, such as barium-strontium-aluminosilicate (BSAS). BSAS may have a lower modulus than rare earth silicates, which, similar to closed pores, may lower the effective modulus of the at least one layer. In some examples, the EBC may include at least one additional layer, such as at least one of a layer including a rare earth disilicate and a columnar microstructure, a layer including BSAS and closed porosity, or a bond coat layer including silicon metal. These additional layers may provide desired characteristics to the EBC.

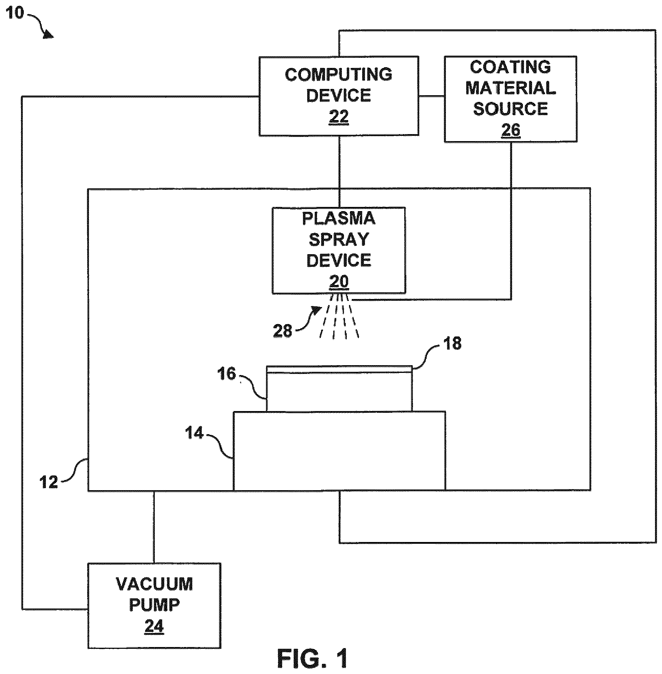

FIG. 1 is a conceptual and schematic diagram illustrating an example system 10 for forming an EBC 18 including at least one layer that includes a rare earth disilicate and closed porosity using PS PVD. System 10 includes a vacuum chamber 12, which encloses a stage 14, and a plasma spray device 20. System 10 also includes a vacuum pump 24, a coating material source 26, and a computing device 22. A substrate 16 is disposed in enclosure 12 and includes EBC 18.

Vacuum chamber 12 may substantially enclose (e.g., enclose or nearly enclose) stage 14, substrate 16, and plasma spray device 20. Vacuum chamber 12 is fluidically connected to at least one vacuum pump 24, which is operable to pump fluid (e.g., gases) from the interior of vacuum chamber 12 to establish a vacuum in vacuum chamber 12. In some examples, vacuum pump 24 may include multiple pumps or multiple stages of a pump, which together may evacuate vacuum chamber 12 to high vacuum. For example, vacuum pump 24 may include at least one of a scroll pump, a screw pump, a roots pump, a turbomolecular pump, or the like. As used herein, high vacuum may refer to pressures of less than about 10 torr (about 1.33 kilopascals (kPa)). In some examples, the pressure within vacuum chamber 12 during the PS-PVD technique may be between about 0.5 torr (about 66.7 pascals) and about 10 torr (about 1.33 kPa).

In some examples, during the evacuation process, vacuum chamber 12 may be backfilled with a substantially inert atmosphere (e.g., helium, argon, or the like), then the substantially inert gases removed during subsequent evacuation to the target pressure (e.g., high vacuum). In this way, the gas molecules remaining in vacuum chamber 12 under high vacuum may be substantially inert, e.g., to substrate 16 and multilayer, multi-microstructure EBC 18.

In some examples, stage 14 may be configured to selectively position and restrain substrate 16 in place relative to stage 14 during formation of multilayer, multi-microstructure EBC 18. In some examples, stage 14 is movable relative to plasma spray device 20. For example, stage 14 may be translatable and/or rotatable along at least one axis to position substrate 16 relative to plasma spray device 20. Similarly, in some examples, plasma spray device 20 may be movable relative to stage 14 to position plasma spray device 20 relative to substrate 16.

Plasma spray device 20 includes a device used to generate a plasma 28 for use in the PS PVD technique. For example, plasma spray device 20 may include a plasma spray gun including a cathode and an anode separated by a plasma gas channel. As the plasma gas flows through the plasma gas channel, a voltage may be applied between the cathode and anode to cause the plasma gas to form the plasma 28. In some examples, the coating material may be injected inside plasma spray device 20 such that the coating material flows through part of the plasma gas channel. In some examples, the coating material may be introduced to the plasma external to plasma spray device 20, as shown in FIG. 1. In some examples, the coating material may be a relatively fine powder (e.g., an average particle size of less than about 5 micrometers) to facilitate vaporization of the coating material by the plasma. In some examples, the relatively fine powder may be agglomerated into a composite powder that serves as the material fed to plasma spray device 20. The composite powder may have a particle size that is larger than the relatively fine powder.

Coating material source 26 may include at least one source of material which is injected into the plasma 28 generated by plasma spray device 20 and deposited in a layer EBC 18 on substrate 16. In some examples, the material may be in powder form, and may be supplied by coating material source 26 carried by a fluid, such as air, an inert gas, or the like.

EBC 18 may include at least one layer including at least one rare earth disilicate (RE₂Si₂O₇, where RE is a rare earth element selected from the group consisting of lutetium, ytterbium, thulium, erbium, holmium, dysprosium, terbium, gadolinium, europium, samarium, promethium, neodymium, praseodymium, cerium, lanthanum, yttrium, and scandium). As such, in some examples, system 10 may include a single coating material source 26. In some examples, in addition to the at least one layer including the at least one rare earth disilicate, EBC 18 may include at least one additional layer. Hence, in some examples, system 10 may include multiple coating material sources 26, e.g., one coating material source for each distinct layer chemistry.

In some examples, the coating material for a layer including at least one rare earth disilicate may include particles, such as particles including a rare earth oxide, particles that include silica, or both, where the particles including rare earth oxide are separate from the particles including silica, and are mechanically mixed in a powder mixture.. In other examples, the coating material for a layer including at least one rare earth disilicate or at least one rare earth monosilicate may include particles in which rare earth oxide and silica are chemically reacted as a rare earth disilicate or a rare earth monosilicate. In other examples, the particles including rare earth oxide may be agglomerated with particles including silica to form larger particles. For example, particles of rare earth oxide and particles of silica may be mixed and agglomerated such that the agglomerated particles include a ratio of moles of rare earth oxide to moles of silica in an approximately stoichiometric amount for the disilicate.

In some examples, a coating material provided by coating material source 26 may include additional and optional constituents of a layer of multilayer, multi-microstructure EBC 18. For example, the additional and optional constituents in a layer including at least one rare earth disilicate may include BSAS, alumina, an alkali metal oxide, an alkaline earth metal oxide, TiO₂, Ta₂O₅, HfSiO₄, or the like. The additive may be added to the layer to modify one or more desired properties of the layer. For example, the additive components may increase or decrease the modulus of the layer, may decrease the reaction rate of the layer with calcia-magnesia-alumina-silicate (CMAS; a contaminant that may be present in intake gases of gas turbine engines), may modify the viscosity of the reaction product from the reaction of CMAS and constituent(s) of the layer, may increase adhesion of the layer to an adjacent layer, may increase the chemical stability of the layer, may decrease the steam oxidation rate, or the like.

Computing device 22 may include, for example, a desktop computer, a laptop computer, a workstation, a server, a mainframe, a cloud computing system, or the like. Computing device 22 may include or may be one or more processors, such as one or more digital signal processors (DSPs), general purpose microprocessors, application specific integrated circuits (ASICs), field programmable logic arrays (FPGAs), or other equivalent integrated or discrete logic circuitry. Accordingly, the term "processor," as used herein may refer to any of the foregoing structure or any other structure suitable for implementation of the techniques described herein. In addition, in some examples, the functionality of computing device 22 may be provided within dedicated hardware and/or software modules.

Computing device 22 is configured to control operation of system 10, including, for example, stage 14, plasma spray device 20, and/or vacuum pump 24. Computing device 22 may be communicatively coupled to at least one of stage 14, plasma spray device 20, and/or vacuum pump 24 using respective communication connections. Such connections may be wireless and/or wired connections.

Computing device 22 may be configured to control operation of stage 14 and/or plasma spray device 20 to position substrate 16 relative to plasma spray device 20. For example, as described above, computing device 22 may control plasma spray device 20 to translate and/or rotate along at least one axis to position substrate 16 relative to plasma spray device 20.

As described above, system 10 may be configured to perform a PS PVD technique to deposit EBC 18 on substrate 16. In some examples, substrate 16 may include component of a high temperature mechanical system, such as a gas turbine engine. For example, substrate 16 may be part of a seal segment, a blade track, an airfoil, a blade, a vane, a combustion chamber liner, or the like. In some examples, substrate may include a ceramic or a CMC. Example ceramic materials may include, for example, silicon carbide (SiC), silicon nitride (Si₃N₄), alumina (Al₂O₃), aluminosilicate, silica (SiO₂), transition metal carbides and silicides (e.g. WC, Mo₂C, TiC, MoSi₂, NbSi₂, TiSi₂),or the like. In some examples, substrate 16 additionally may include silicon metal, carbon, or the like. In some examples, substrate 16 may include mixtures of two or more of SiC, Si₃N₄, Al₂O₃, aluminosilicate, silica, silicon metal, carbon, or the like.

In examples in which substrate 16 includes a CMC, substrate 16 includes a matrix material and a reinforcement material. The matrix material includes a ceramic material, such as, for example, silicon metal, SiC, or other ceramics described herein. The CMC further includes a continuous or discontinuous reinforcement material. For example, the reinforcement material may include discontinuous whiskers, platelets, fibers, or particulates. As other examples, the reinforcement material may include a continuous monofilament or multifilament weave. In some examples, the reinforcement material may include SiC, C, other ceramic materials described herein, or the like. In some examples, substrate 16 includes a SiC-SiC ceramic matrix composite.

In some examples, system 10 may be used to perform PS PVD to deposit EBC 18 on surfaces of substrate 16, including NLOS surfaces (e.g., at least partially obstructed surfaces) of substrate 16. PS PVD is a flexible process that allows relatively easy adjustment of process parameters to result in coatings with different chemistry, microstructure, or both. In this way, system 10 may utilize PS PVD to deposit EBC 18 that at least one layer including at least one rare earth disilicate and closed porosity on surfaces of substrate 16, including at least partially obstructed surfaces.

Computing device 22 may be configured to control operation of system 10 (e.g., vacuum pump 24, plasma spray device 20, and coating material source 26) to perform PS PVD to deposit EBC 18. PS PVD may operate at low operating pressures, such as between about 0.5 torr and about 10 torr. In some examples, the temperatures of the plasma may be greater than about 6000 K, which may vaporize the coating material. Because the vaporized coating material is carried by a gas stream, PS PVD may allow deposition multilayer, multi-microstructure EBC 18 on surfaces of substrate 16 that are not in line-of-sight relationship with plasma spray device 20, unlike thermal spray processes, such as air plasma spraying. Further, a deposition rate (e.g., thickness of coating deposited per unit time) may be greater for PS PVD than for other vapor phase deposition processes, such as chemical vapor deposition or physical vapor deposition, which may result in PS PVD being a more economical coating technique.

In some examples, EBC 18 includes at least one layer that includes at least one rare earth disilicate and substantially closed porosity. The at least one rare earth disilicate may have good thermal expansion compatibility with the underlying CMC. Further, including closed porosity may reduce the modulus of the at least one layer that includes at least one rare earth disilicate, thus reducing the stress caused by thermal cycling and reducing a likelihood of cracks developing in the at least one layer. Further, closed porosity does not provide paths through which water vapor can migrate from the outer surface of the at least one layer to the inner surface of the at least one layer, allowing the at least one layer to form an effective vapor barrier for the substrate. In some examples, the at least one layer including the at least one rare earth disilicate and the closed porosity may be substantially free (e.g., free or nearly free) of open porosity or columnar microstructure.

In this way, the at least one layer including the at least one rare earth disilicate and closed porosity may substantially prevent (e.g., prevent or nearly prevent) environmental species such as water vapor, oxygen, molten salt, or calcia-magnesia-alumina-silicate (CMAS) deposits from contacting substrate 16 and degrading the material structure of substrate 16. For example, water vapor may react with a substrate 16 including a CMC and volatilize silica or alumina components in substrate 16.

System 10 may utilize PS PVD to deposit the at least one layer including at least one rare earth disilicate and closed porosity. For example, the rate at which coating material is fed by coating material source 26 into plasma 28 may affect the amount of the coating material that is vaporized by plasma 28. A higher rate of coating material being fed into plasma 28 may reduce the amount of the coating material that is vaporized by plasma 28. When substantially all of the coating material is vaporized, the resulting deposited layer may be substantially dense, while when less coating material is vaporized, the resulting deposited layer may include closed porosity. When even less coating material is vaporized, the resulting deposited layer may include open porosity or a columnar microstructure. Hence, by controlling the rate of coating material fed by coating material source 26 into plasma 28, computing device 22 may cause the at least one layer including at least one rare earth disilicate and closed porosity to be deposited on substrate 16.

In some examples the at least one layer including the at least one rare earth disilicate and closed porosity includes porosity of between about 5 vol. % and about 30 vol. %, such as between 10 vol. % and about 20 vol. %, where porosity is defined as the volume of the pores divided by the total volume of the at least one rare earth disilicate and closed porosity. Open porosity may be measure by techniques such as mercury porosimetry. Closed porosity may be measured by techniques such as optical image analysis which can visually differentiate open and closed porosity.

A rare earth disilicate is a compound formed by chemically reacting a rare earth oxide and silica in a particular stoichiometric ratio (1 mole rare earth oxide and 2 moles silica) under sufficient conditions (e.g., heat and/or pressure) to cause the rare earth oxide and the silica to react. A rare earth disilicate is chemically distinct from a mixture of free rare earth oxide and free silica. For example, a rare earth disilicate has different chemical and physical properties than a mixture of free rare earth oxide and free silica.

In some examples, the coating material may include excess silica compared to the desired amount of silica in the at least one layer including the at least one rare earth disilicate and closed porosity. In some examples, the excess silica may be mixed in the coating material as a separate powder. In other examples, the excess silica may be part of an agglomerate in the coating material with the rare earth oxide or rare earth disilicate.

The excess silica in the coating source may facilitate formation of a layer with a desired composition. Silica may have a higher vapor pressure than rare earth oxides, at a given pressure and temperature. This may result in silica being more likely to be lost via volatilization during the processing, such that silica deposits in the at least one layer in a lower ratio than the ratio of silica to rare earth oxide in the coating material. Thus, by including excess silica in a predetermined amount, the at least one layer may be formed with a desired amount of silica. For example, the excess amount of silica may be selected such that the ratio of silica to earth oxide deposited in the first layer is substantially the same as a stoichiometric ratio of the desired rare earth disilicate. In other examples, the amount of silica in the coating material may be selected to result in a predetermined amount of excess silica or excess rare earth oxide in the layer being deposited compared to a stoichiometric ratio of rare earth oxide to silica in the desired rare earth silicate. This may result in a selected amount of free silica or free rare earth oxide in the layer of multilayer, multi-microstructure EBC 18.

The amount of excess silica included in the coating material may depend on the desired composition of the at least one layer including the at least one rare earth disilicate and closed porosity, and may be based on experimental testing. For example, a first coating material having a first ratio of silica to rare earth oxide may be formed and a coating deposited from the coating material using PS PVD. The composition of the resulting coating may be determined, and the ratio of silica to rare earth oxide (e.g., in the form of a rare earth silicate) in the coating may be compared to the ratio of silica to rare earth oxide in the coating material. This process may be repeated to determine an amount of excess silica to include in the coating material to form the at least one layer including the at least one rare earth disilicate and closed porosity with a desired composition.

In some examples, the at least one layer including the at least one rare earth disilicate and closed porosity may consist essentially of or consist of the at least one rare earth disilicate. In other examples, the at least one layer including the at least one rare earth disilicate and closed porosity may include the at least one rare earth disilicate and at least one other element or compound. For example, the at least one layer including the at least one rare earth disilicate and closed porosity may include the rare earth disilicate and at least one of free rare earth oxide, free silica, or rare earth monosilicate.

Additionally and optionally, the at least one layer including the at least one rare earth disilicate and closed porosity may include BSAS. BSAS has a lower modulus than rare earth disilicates, and thus may reduce the modulus of the at least one layer including the at least one rare earth disilicate and closed porosity. As described above, lowering the modulus of the at least one layer including the at least one rare earth disilicate and closed porosity may reduce the likelihood that the at least one layer including the at least one rare earth disilicate and closed porosity cracks under thermal cycling. In some examples, the at least one layer including the at least one rare earth disilicate and closed porosity may include between about 1 wt. % and about 30 wt. % BSAS, such as between about 5 wt. % and about 25 wt. % BSAS, or between about 10 wt. % and about 20 wt. % BSAS.

Also additionally and optionally, the at least one layer including the at least one rare earth disilicate and closed porosity may include at least one dopant. The at least one dopant may include at least one of alumina (Al₂O₃), at least one alkali oxide, or at least one alkaline earth oxide. In some examples, the at least one layer including the at least one rare earth disilicate and closed porosity may include between about 0.1 wt. % and about 5 wt. % of the at least one dopant. In some examples in which the at least one dopant includes alumina, first layer 38 may include between about 0.5 wt. % and about 3 wt. % alumina or between about 0.5 wt. % and about 1 wt. % alumina. In some examples in which the at least one dopant includes the at least one alkali oxide, first layer 38 may include between about 0.1 wt. % and about 1 wt. % of the at least one alkali oxide. In some examples in which the at least one dopant includes the at least one alkaline earth oxide, first layer 38 may include between about 0.1 wt. % and about 1 wt. % of the at least one alkaline earth oxide. The at least one dopant may affect chemical and physical properties of first layer 38, including, for example, steam oxidation resistance, calcia-magnesia-alumina-silicate (CMAS) resistance, thermal expansion coefficient, and the like.

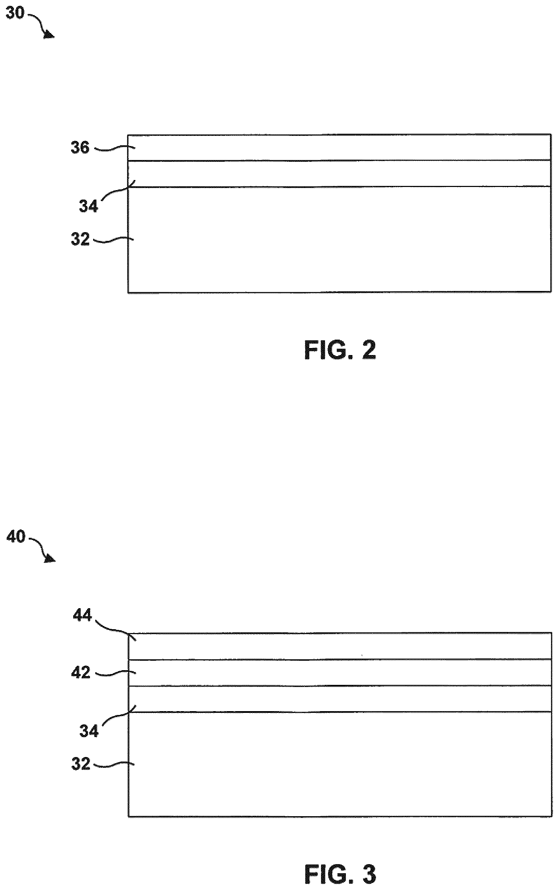

Although EBC 18 including the at least one layer including the at least one rare earth disilicate and closed porosity may provide the properties described above, including coefficient of thermal expansion match with substrate 16, water vapor recession resistance, and the like, in some examples, an EBC may include additional, optional layers. For example, FIG. 2 is a conceptual block diagram illustrating an example article 30 including a substrate 32, a bond coat layer 34, and at least one layer including the at least one rare earth disilicate and closed porosity 36. Substrate 32 may include any of the materials described above with respect to substrate 16 of FIG. 1, and article 30 may include any of the articles described above with respect to FIG. 1.

Article 30 also includes an optional bond coat layer 34. Bond coat layer 34 may include, for example, silicon metal, alone, or mixed with at least one other constituent. For example, bond coat layer 34 may include silicon metal and at least one of a transition metal carbide, a transition metal boride, a transition metal nitride, mullite (aluminum silicate, Al₆Si₂O₁₃), silica, a silicide, an oxide (e.g., silicon oxide, a rare earth oxide, an alkali oxide, or the like), a silicate (e.g., a rare earth silicate or the like), or the like. In some examples, the additional constituent(s) may be substantially homogeneously mixed with silicon metal. In other examples, the additional constituent(s) may form a second phase distinct from the silicon metal phase.

In some examples, system 10 (FIG. 1) may be used to deposit bond coat layer 34 on substrate 32 using PS PVD. For example, system 10 may deposit bond coat layer 34 as a substantially dense layer (e.g., a porosity of less than about 10 vol. %, such as, less than about 5 vol. %, where porosity is measured as a percentage of pore volume divided by total layer volume). As another examples, system 10 may deposit bond coat layer 34 as a layer including closed porosity. As defined above, closed porosity means that the pores are not interconnected throughout a thickness of bond coat layer 34. In other words, while some pores may be interconnected within the bond coat layer 34, the interconnection is not so extensive that a path extends from an outer surface of bond coat layer 34 to the inner surface of bond coat layer 34. In this way, closed porosity is different from open porosity and is different from a columnar microstructure, both of which include paths through the thickness of a layer through which gases or vapors can migrate.

Similar to the at least one layer including the at least one rare earth disilicate described above, closed porosity in bond coat layer 34 may reduce the modulus of bond coat layer 34. This may reduce stress in bond coat layer 34 during thermal cycling due to coefficient of thermal expansion mismatch between bond coat layer 34 and substrate 32, and, thus, may reduce the likelihood that bond coat layer 34 cracks under thermal cycling. In some examples in which bond coat layer 34 includes closed porosity, bond coat layer 34 includes porosity of between about 5 vol. % and about 30 vol. %, such as between 10 vol. % and about 20 vol. %, where porosity is defined as the volume of the pores divided by the total volume of bond coat layer 34.

At least one layer including the at least one rare earth disilicate and closed porosity 36 may be similar to or substantially the same as at least one layer including the at least one rare earth disilicate and closed porosity described above with reference to EBC 18 of FIG. 1. For example, at least one layer including the at least one rare earth disilicate and closed porosity 36 may include, consist essentially of, or consists or at least one rare earth disilicate. In some examples, at least one layer including the at least one rare earth disilicate and closed porosity 36 may optionally include at least one other constituent, such as at least one of silica, a rare earth oxide, BSAS, or a dopant, such as at least one of alumina (Al₂O₃), at least one alkali oxide, or at least one alkaline earth oxide. In some examples, at least one layer including the at least one rare earth disilicate and closed porosity 36 may be substantially free of open porosity or columnar microstructure.

FIG. 3 is a conceptual block diagram illustrating another example article 40 including a substrate 32 and an environmental barrier coating including a layer including closed porosity and at least one rare earth disilicate 42 and a layer including a columnar microstructure and a rare earth disilicate 44. Additionally and optionally, article 40 includes bond coat layer 34. Substrate 32 and bond coat layer 34 may be similar to or substantially the same as the corresponding layers described with reference to FIG. 2. Layer including closed porosity and at least one rare earth disilicate 42 may be similar to or substantially the same as at least one layer including the at least one rare earth disilicate and closed porosity 36 described with reference to FIG. 2.

Additionally, article 40 of FIG. 3 includes layer including a columnar microstructure and a rare earth disilicate 44. A columnar microstructure may have microcracks or microgaps that extend through at least a portion of layer including a columnar microstructure and a rare earth disilicate 44 in a direction that is substantially orthogonal to the plane defined by the layer surface. Because of the microgaps, a columnar microstructure may have enhanced mechanical compliance under thermal cycling or when a temperature gradient exists, such as when a high-temperature system is first engaged. Additionally, a layer having a columnar microstructure may provide improved thermal protection to substrate 16 compared to a layer that is substantially nonporous. While not wishing to be bound by theory, the microcracks or microgaps may provide scattering sites for thermal energy-carrying phonons, which may lower an effective thermal conductivity of a layer having a columnar microstructure compared to a substantially nonporous layer of a similar composition. Further, presence of layer including a columnar microstructure and a rare earth disilicate 44 may result in reduced velocity of water vapor at the surface of layer including closed porosity and at least one rare earth disilicate 42, reducing or substantially preventing recession of layer including closed porosity and at least one rare earth disilicate 42.

In some examples, thermal protection and mechanical compliance are not the only benefits of a columnar microstructure. A layer (e.g., layer 44) having a columnar microstructure may also exhibit enhanced erosion resistance and enhanced sintering resistance relative to a layer that does not include a columnar microstructure.

In some examples, the rare earth disilicate in layer including a columnar microstructure and a rare earth disilicate 44 may be the same as the rare earth disilicate in layer including closed porosity and at least one rare earth disilicate 42. In other examples, the rare earth disilicate in layer including a columnar microstructure and a rare earth disilicate 44 may be different than the rare earth disilicate in layer including closed porosity and at least one rare earth disilicate 42.

Similarly, in some examples, layer including a columnar microstructure and a rare earth disilicate 44 may additionally and optionally include other constituents, such as a rare earth oxide, silica, BSAS, or at least one dopant, such as at least one of alumina (Al₂O₃), at least one alkali oxide, or at least one alkaline earth oxide. In some examples, the overall composition of layer including a columnar microstructure and a rare earth disilicate 44 may be similar to or substantially the same as layer including closed porosity and at least one rare earth disilicate 42, while in other examples, the overall composition of layer including a columnar microstructure and a rare earth disilicate 44 may be different than the composition of layer including closed porosity and at least one rare earth disilicate 42.

In some examples, rather than including a single layer including closed porosity and at least one rare earth disilicate 42 and a single layer including a columnar microstructure and a rare earth disilicate 44, an EBC may include alternating layers, where alternate layers include closed porosity and at least one rare earth disilicate (similar to layer 42) and other alternate layers including a columnar microstructure and a rare earth disilicate (similar to layer 44). An EBC may include as many alternating layers of layers 42 and layers 44 as desired. The alternating layers may result in an EBC with a relatively low modulus, due to the closed porosity in some layers and the columnar microstructure in other layers, and the interfaces between the layers may provide phonon scattering points that reduces the overall thermal conductivity of the EBC.

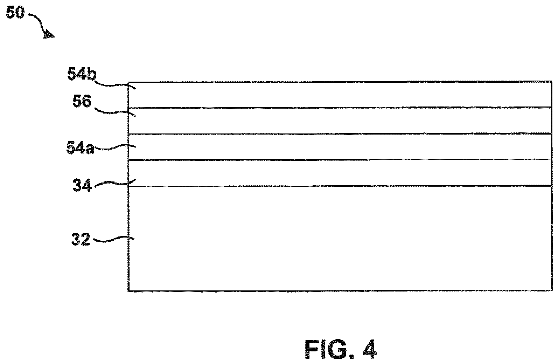

FIG. 4 is a conceptual block diagram illustrating an example article 50 including a substrate 32 and a multilayer environmental barrier coating including alternating layers including closed porosity and a rare earth disilicate 54a, 54b and including BSAS and closed porosity 56. Additionally and optionally, article 50 includes bond coat layer 34. Substrate 32 and bond coat layer 34 may be similar to or substantially the same as the corresponding layers described with reference to FIG. 2. Layers including closed porosity and at least one rare earth disilicate 54a, 54b may be similar to or substantially the same as at least one layer including the at least one rare earth disilicate and closed porosity 36 described with reference to FIG. 2.

Additionally, article 50 includes a layer including BSAS and closed porosity 56. As described above, closed porosity means that the pores are not interconnected throughout a thickness of the at least one layer. In other words, while some pores may be interconnected within the at least one layer, the interconnection is not so extensive that a path extends from an outer surface of the at least one layer to the inner surface of the at least one layer. In this way, closed porosity is different from open porosity and is different from a columnar microstructure, both of which include paths through the thickness of a layer through which gases or vapors can migrate.

As BSAS has a lower modulus than rare earth disilicate and closed porosity further lowers the modulus of layer including BSAS and closed porosity 56, the layer including BSAS and closed porosity 56 may have a relatively low modulus, which may reduce stress in layer including BSAS and closed porosity 56 during thermal cycling due to differences in coefficients of thermal expansion between substrate 32 and layers 54a, 54b, and 56 of the EBC. In this way, layer including BSAS and closed porosity 56 may contribute to a reduced propensity to cracking under thermal cycling, while still acting as a barrier layer to water vapor or other gases due to the closed porosity.

PS PVD may be used to deposit layer including BSAS and closed porosity 56. For example, the rate at which coating material is fed by coating material source 26 into plasma 28 may affect the amount of the coating material that is vaporized by plasma 28. A higher rate of coating material being fed into plasma 28 may reduce the amount of the coating material that is vaporized by plasma 28. When substantially all of the coating material is vaporized, the resulting deposited layer may be substantially dense, while when less coating material is vaporized, the resulting deposited layer may include closed porosity. When even less coating material is vaporized, the resulting deposited layer may include open porosity or a columnar microstructure. Hence, by reducing the rate of coating material fed by coating material source 26 into plasma 28, computing device 22 may cause layer including BSAS and closed porosity 56 to be deposited on first layer including closed porosity and at least one rare earth disilicate 54a.

The alternating layers may result in an EBC with a relatively low modulus, due to the closed porosity in some layers and the columnar microstructure in other layers, and the interfaces between the layers may provide phonon scattering points that reduces the overall thermal conductivity of the EBC.

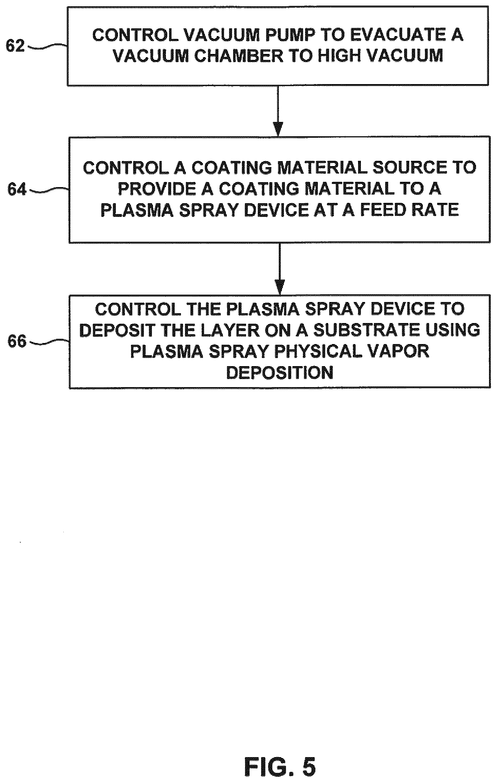

FIG. 5 is a flow diagram illustrating an example technique for forming a coating that includes an environmental barrier coating including at least one layer including at least one rare earth disilicate and closed porosity using PS PVD. The technique of FIG. 5 will be described with respect to system 10 of FIG. 1 and article 30 of FIG. 2 for ease of description only. A person having ordinary skill in the art will recognize and appreciate that the technique of FIG. 5 may be implemented using systems other than system 10 of FIG. 1, may be used to form articles other than article 30 of FIG. 2 (such as article 40 of FIG. 3 or article 50 of FIG. 4), or both.

The technique of FIG. 5 may include, controlling, by computing device 22, vacuum pump 24 to evacuate vacuum chamber 12 to a high vacuum (62). As described above, vacuum pump 24 may be used to evacuate vacuum chamber 12 to high vacuum, e.g., less than about 10 torr (about 1.33 kPa), or between about 0.5 torr (about 66.7 pascals) and about 10 torr (about 1.33 kPa). In some examples, computing device 22 may control vacuum pump 24 and a source of substantially inert gas (e.g., helium, argon, or the like) to evacuate vacuum chamber 12 in multiple pump-downs. For example, computing device 22 may control vacuum pump 24 to evacuate vacuum chamber 12 of the atmosphere present when substrate 16 is placed in vacuum chamber 12. Computing device 22 then may control the source of the substantially inert gas to fill vacuum chamber 12 with the substantially inert gas. Computing device 22 may control vacuum pump 24 to evacuate vacuum chamber 12 of the substantially inert gas (and remaining atmosphere). In some examples, computing device 22 may control the source of the substantially inert gas and vacuum pump 24 to fill and evacuate vacuum chamber 12 at least one time (e.g., a plurality of times) to substantially remove reactive gases from vacuum chamber 12 and leave substantially only inert gases such as helium, argon, or the like in vacuum chamber 12.

The technique of FIG. 5 also may include, controlling, by computing device 22, coating material source 26 to provide a coating material to plasma spray device 20 at a feed rate (64). As described above, the first coating material may include silica and at least one rare earth oxide. The amount of the at least one rare earth oxide and the amount of silica may be selected so that at least one layer including at least one rare earth disilicate and closed porosity 36 deposited from the coating material includes a predetermined ratio of the at least one rare earth oxide and silica. In some examples, due to the differences in vapor pressure between rare earth oxides and silica, the ratio of the at least one rare earth oxide and silica in the coating material provided by coating material source 26 may include additional silica compared to the composition of at least one layer including at least one rare earth disilicate and closed porosity 36, as described above.

The excess silica in the coating source may facilitate formation of at least one layer including at least one rare earth disilicate and closed porosity 36 including a rare earth disilicate. As described above, silica may have a higher vapor pressure than some rare earth oxides, at a given pressure and temperature. This may result in silica being more likely to be lost via volatilization during the processing, such that silica deposits in at least one layer including at least one rare earth disilicate and closed porosity 36 in a lower ratio than the ratio of silica to rare earth oxide in the first coating material. Thus, by including excess silica in a predetermined amount, at least one layer including at least one rare earth disilicate and closed porosity 36 may be formed with a desired amount of silica. For example, the excess amount of silica may be selected such that the ratio of silica to rare earth oxide deposited in at least one layer including at least one rare earth disilicate and closed porosity 36 is substantially the same as a stoichiometric ratio of the rare earth disilicate. In other examples, the amount of silica in the coating material may be selected to result in a predetermined amount of excess silica or excess rare earth oxide in at least one layer including at least one rare earth disilicate and closed porosity 36 compared to a stoichiometric ratio of rare earth oxide to silica in the rare earth disilicate. This may result in a selected amount of free silica or free rare earth oxide in at least one layer including at least one rare earth disilicate and closed porosity 36.

The feed rate may be selected so PS PVD of the coating material results in at least one layer including at least one rare earth disilicate and closed porosity 36 including closed porosity. As described above, closed porosity means that the pores are not interconnected throughout a thickness of the at least one layer. In other words, while some pores may be interconnected within the at least one layer, the interconnection is not so extensive that a path extends from an outer surface of the at least one layer to the inner surface of the at least one layer. In this way, closed porosity is different from open porosity and is different from a columnar microstructure, both of which include paths through the thickness of a layer through which gases or vapors can migrate. In some examples, at least one layer including at least one rare earth disilicate and closed porosity 36 may be substantially free (e.g., free or nearly free) of open porosity and columnar microstructure.

For example, computing device 22 may control the feed rate to be relatively low, such that nearly all of the coating material that coating material source 26 provides to plasma spray device 20 is vaporized. When at least one layer including at least one rare earth disilicate and closed porosity 36 is deposited from nearly fully vaporized first coating material, the resulting microstructure of at least one layer including at least one rare earth disilicate and closed porosity 36 may include closed porosity, and, in some examples, may be substantially free of open porosity and columnar microstructure.

In some examples, in addition to controlling the feed rate of coating material to plasma spray device 20, the coating material may include a fugitive material, which is removed (e.g., burned out) after deposition of at least one rare earth disilicate and closed porosity 36 to form the closed porosity. The fugitive material may include, for example, at least one of molybdenum, tungsten, boron nitride, a polymer, or graphite. The amount of fugitive material may be selected based on a desired porosity volume percent in at least one rare earth disilicate and closed porosity 36.

The technique of FIG. 5 also includes controlling, by computing device 22, plasma spray device 20 to deposit at least one rare earth disilicate and closed porosity 36 on substrate 16 (66). As described above, at least one rare earth disilicate and closed porosity 36 may include a rare earth disilicate formed by reaction of the silica and the at least one rare earth oxide. During the PS PVD technique, the coating material may be introduced into plasma 28, e.g., internally or externally to plasma spray device 20. In PS PVD, vacuum chamber 12 is at a pressure lower than that used in low pressure plasma spray. For example, as described above, computing device 22 may control vacuum pump 24 to evacuate vacuum chamber 12 to a high vacuum with a pressure of less than about 10 torr (about 1.33 kPa). In contrast, in low pressure plasma spray, the pressure in a vacuum chamber is between about 50 torr (about 6.67 kPa) and about 200 torr (about 26.66 kPa). Because of the lower operating pressure, the plasma may be larger in both length and diameter, and may have a relatively uniform distribution of temperature and particle velocity.

The temperature of plasma 28 may, in some examples, be above about 6000 K, which may result in vaporization of nearly all of the coating material, depending upon the rate of introduction of the coating material to the plasma 28. Plasma 28 may carry the coating material toward substrate 16, where the coating material deposits in a layer on substrate 16. Because the coating material is carried by plasma 28 toward substrate 16, PS PVD may provide some non line-of-sight capability, depositing coating material on at least partially obstructed surfaces (surfaces that are not in direct line of sight with plasma spray device 20). This may facilitate forming at least one rare earth disilicate and closed porosity 36 on substrates with more complex geometry (e.g., non-planar geometry).

Although not shown in FIG. 5, the technique additionally and optionally may include, controlling, by computing device 22, coating material source 26 to provide other coating materials to plasma spray device 20 at a selected feed rate to deposit other, optional layers, such as bond coat layer 34 (FIGS. 2-4), layer including a columnar microstructure and a rare earth disilicate 44 (FIG. 3), layer including BSAS and closed porosity 56 (FIG. 4), or the like.

In some examples, during the PS-PVD technique, computing device 22 may control plasma spray device 20, stage 14, or both to move plasma spray device 20, substrate 16, or both relative to each other. For example, computing device 22 may be configured to control plasma spray device 20 to scan the plasma plume relative to substrate 16.

The techniques described in this disclosure may be implemented, at least in part, in hardware, software, firmware, or any combination thereof. For example, various aspects of the described techniques may be implemented within one or more processors, including one or more microprocessors, digital signal processors (DSPs), application specific integrated circuits (ASICs), field programmable gate arrays (FPGAs), or any other equivalent integrated or discrete logic circuitry, as well as any combinations of such components. The term "processor" or "processing circuitry" may generally refer to any of the foregoing logic circuitry, alone or in combination with other logic circuitry, or any other equivalent circuitry. A control unit including hardware may also perform one or more of the techniques of this disclosure.

Such hardware, software, and firmware may be implemented within the same device or within separate devices to support the various techniques described in this disclosure. In addition, any of the described units, modules or components may be implemented together or separately as discrete but interoperable logic devices. Depiction of different features as modules or units is intended to highlight different functional aspects and does not necessarily imply that such modules or units must be realized by separate hardware, firmware, or software components. Rather, functionality associated with one or more modules or units may be performed by separate hardware, firmware, or software components, or integrated within common or separate hardware, firmware, or software components.

The techniques described in this disclosure may also be embodied or encoded in a computer system-readable medium, such as a computer system-readable storage medium, containing instructions. Instructions embedded or encoded in a computer system-readable medium, including a computer system-readable storage medium, may cause one or more programmable processors, or other processors, to implement one or more of the techniques described herein, such as when instructions included or encoded in the computer system-readable medium are executed by the one or more processors. Computer system readable storage media may include random access memory (RAM), read only memory (ROM), programmable read only memory (PROM), erasable programmable read only memory (EPROM), electronically erasable programmable read only memory (EEPROM), flash memory, a hard disk, a compact disc ROM (CD-ROM), a floppy disk, a cassette, magnetic media, optical media, or other computer system readable media. In some examples, an article of manufacture may comprise one or more computer system-readable storage media.

### EXAMPLES

### Example 1

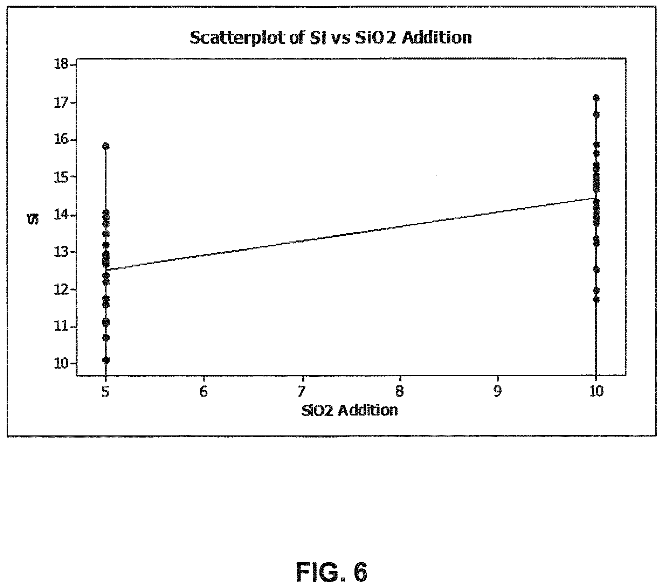

FIG. 6 is a scatter diagram illustrating an example relationship between excess silica in a coating material and an amount of silicon in a resulting coating. The units on the x-axis of FIG. 6 are weight percent excess silica (SiO₂) in the coating material. Excess silica is defined with reference to a stoichiometric amount of silica in the coating material. In this example, the coating material includes a mixture of silica, ytterbium disilicate (Yb₂Si₂O₇), and alumina. For the samples with 5 wt. % excess silica, the mixture included 1 wt. % alumina and a balance ytterbium disilicate. For the samples with 5 wt. % excess silica, the mixture included 3 wt. % alumina and a balance ytterbium disilicate. The units on the y-axis of FIG. 6 are weight percent elemental silicon (Si) in the resulting coating, as measured by a microprobe. A stoichiometric ytterbium disilicate would include about 10.9 wt. % silicon. As shown in FIG. 6, increasing excess silica in the coating material generally increased the amount of silicon in the resulting coating.

### Example 2

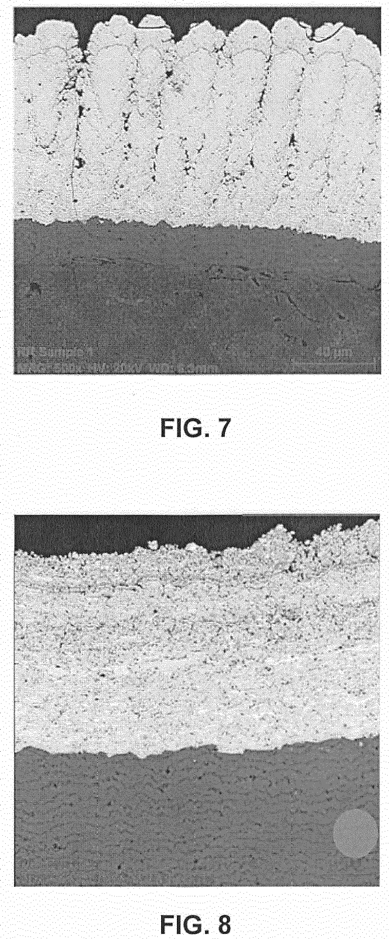

FIG. 7is a cross-sectional picture of an example coating deposited using PS-PVD as described in this disclosure. The coating illustrated in FIG. 7was deposited from a coating material including 5 wt. % excess silica, 1 wt. % alumina and a balance ytterbium disilicate. The PS-PVD parameters included using a He carrier gas with oxygen introduced into the PS-PVD chamber. The power was about 119.9 kW, and the coating time was about 12 minutes and 30 seconds. The coating was applied directly to the substrate with a line-of-sight relationship. As shown in FIG. 7, with these conditions, the coating included a columnar microstructure.

### Example 3

FIG. 8 is a cross-sectional picture of an example coating deposited using PS-PVD as described in this disclosure. The coating illustrated in FIG. 8 was deposited from a coating material including 5 wt. % excess silica, 3 wt. % alumina and a balance ytterbium disilicate. The PS-PVD parameters included using a carrier gas with oxygen introduced into the PS-PVD chamber. The power was about 116.6 kW, and the coating time was about 12 minutes. The coating was applied directly to the substrate with a line-of-sight relationship. As shown in FIG. 8, with these conditions, the coating included a porous microstructure, including closed pores that do not extend through the thickness of the coating.

### Example 4

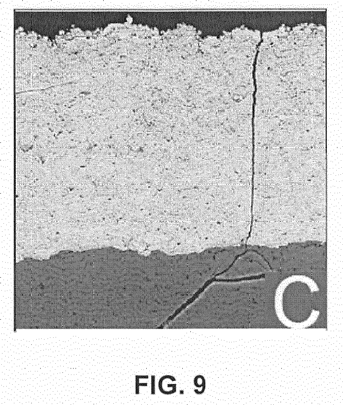

FIG. 9 is a cross-sectional picture of an example coating deposited using PS-PVD as described in this disclosure. The coating illustrated in FIG. 9 was deposited from a coating material including 5 wt. % excess silica, 3 wt. % alumina and a balance ytterbium disilicate. The PS-PVD parameters included using a He carrier gas with no oxygen introduced into the PS-PVD chamber. The power was about 117.0 kW, and the coating time was about 17 minutes and 30 seconds. The coating was applied directly to the substrate with a line-of-sight relationship. As shown in FIG. 9, with these conditions, the coating included a substantially dense microstructure.

Various examples have been described. These and other examples are within the scope of the following claims.

## Claims

1. An article comprising:
a substrate defining at least one at least partially obstructed surface, wherein the substrate comprises at least one of a ceramic or a ceramic matrix composite; and
an environmental barrier coating on the at least partially obstructed substrate, wherein the environmental barrier coating comprises a layer comprising a rare earth disilicate and a microstructure comprising closed porosity.

2. The article of claim 1, wherein the layer consists essentially of the rare earth disilicate.

3. The article of claim 1 or 2, wherein the layer is substantially free of open pores.

4. The article of claim 1, wherein the layer further comprises at least one of alumina, at least one alkali oxide, or at least one alkaline earth oxide.

5. The article of any one of claims 1 to 4, further comprising a silicon bond coat layer between the substrate and the environmental barrier coating.

6. The article of claim 5, wherein the silicon bond coat layer comprises closed porosity and is substantially free of open pores.

7. The article of claim 1, wherein the layer further comprises barium-strontium-aluminosilicate.

8. The article of any one of claims 1 to 6, wherein the layer comprises a first layer, further comprising a second layer on the first layer, wherein the second layer comprises a columnar microstructure and a rare earth disilicate or comprises barium-strontium-aluminosilicate and closed porosity, or
wherein the layer comprises a first layer, further comprising:
a second layer on the first layer, wherein the second layer comprises a columnar microstructure and a rare earth disilicate;
a third layer on the second layer, wherein the third layer comprises a rare earth disilicate and closed porosity; and
a fourth layer on the third layer, wherein the fourth layer comprises a columnar microstructure and a rare earth disilicate.

9. A system comprising:
a vacuum pump;
a vacuum chamber;
a plasma spray device;
a coating material source; and
a computing device operable to:
control the vacuum pump to evacuate the vacuum chamber to high vacuum;
control the coating material source to provide a coating material to the plasma spray device at a feed rate, the coating material having a composition selected so that a layer formed from the coating material comprises a rare earth disilicate, and the feed rate being selected to result in a microstructure including closed porosity; and
control the plasma spray device to deposit the layer on a substrate in the vacuum chamber using plasma spray physical vapor deposition, wherein the layer comprises the rare earth disilicate and closed porosity.

10. The system of claim 9, wherein the computing device is further configured to:
control the coating material source to provide a coating material comprising silicon metal to the thermal spray device;
control the plasma spray device to deposit a bond coat layer on the substrate in the vacuum chamber using plasma spray physical vapor deposition, wherein the layer including the rare earth disilicate is on the bond coat layer.

11. The system of claim 9 or 10, wherein the layer comprises a first layer, the coating material comprises a first coating material, the feed rate comprises a first feed rate, and wherein the computing device is further configured to:
control the coating material source to provide a second coating material to the plasma spray device at a second feed rate, the second coating material having a composition selected so that a layer formed from the coating material comprises a rare earth disilicate, and the feed rate being selected to result in a columnar microstructure; and
control the plasma spray device to deposit the second layer on the first layer in the vacuum chamber using plasma spray physical vapor deposition, wherein the second layer comprises the rare earth disilicate and columnar microstructure, or
wherein the layer comprises a first layer, the coating material comprises a first coating material, the feed rate comprises a first feed rate, and wherein the computing device is further configured to:
control the coating material source to provide a second coating material to the plasma spray device at a second feed rate, the second coating material having a composition selected so that a layer formed from the coating material comprises a barium-strontium-aluminosilicate, and the feed rate being selected to result in closed porosity; and
control the plasma spray device to deposit the second layer on the first layer in the vacuum chamber using plasma spray physical vapor deposition, wherein the second layer comprises the barium-strontium-aluminosilicate and closed porosity.

12. A method comprising:
controlling, by a computing device, a vacuum pump to evacuate the vacuum chamber to high vacuum;
controlling, by the computing device, a coating material source to provide a coating material to the plasma spray device at a feed rate, the coating material having a composition selected so that a layer formed from the coating material comprises a rare earth disilicate, and the feed rate being selected to result in a microstructure including closed porosity; and
controlling, by the computing device, the plasma spray device to deposit the layer on a substrate in the vacuum chamber using plasma spray physical vapor deposition, wherein the layer comprises the rare earth disilicate and closed porosity.

13. The method of claim 12, further comprising:
controlling, by the computing device, the coating material source to provide a coating material comprising silicon metal to the thermal spray device;
controlling, by the computing device, the plasma spray device to deposit a bond coat layer on the substrate in the vacuum chamber using plasma spray physical vapor deposition, wherein the layer including the rare earth disilicate is on the bond coat layer.

14. The method of claim 12 or 13, wherein the layer comprises a first layer, the coating material comprises a first coating material, the feed rate comprises a first feed rate, and further comprising:
controlling, by the computing device, the coating material source to provide a second coating material to the plasma spray device at a second feed rate, the second coating material having a composition selected so that a layer formed from the coating material comprises a rare earth disilicate, and the feed rate being selected to result in a columnar microstructure; and
controlling, by the computing device, the plasma spray device to deposit the second layer on the first layer in the vacuum chamber using plasma spray physical vapor deposition, wherein the second layer comprises the rare earth disilicate and columnar microstructure, or
wherein the layer comprises a first layer, the coating material comprises a first coating material, the feed rate comprises a first feed rate, and further comprising:
controlling, by the computing device, the coating material source to provide a second coating material to the plasma spray device at a second feed rate, the second coating material having a composition selected so that a layer formed from the coating material comprises a barium-strontium-aluminosilicate, and the feed rate being selected to result in closed porosity; and
controlling, by the computing device, the plasma spray device to deposit the second layer on the first layer in the vacuum chamber using plasma spray physical vapor deposition, wherein the second layer comprises the barium-strontium-aluminosilicate and closed porosity.

15. A computer readable storage device comprising instructions that, when executed, cause a computing device to:
control a vacuum pump to evacuate the vacuum chamber to high vacuum;
control a coating material source to provide a coating material to the plasma spray device at a feed rate, the coating material having a composition selected so that a layer formed from the coating material comprises a rare earth disilicate, and the feed rate being selected to result in a microstructure including closed porosity; and
control the plasma spray device to deposit the layer on a substrate in the vacuum chamber using plasma spray physical vapor deposition, wherein the layer comprises the rare earth disilicate and closed porosity.
